# EUROPEAN PATENT APPLICATION

(11) **EP 4 632 793 A1**
(43) Date of publication of application: **15.10.2025**
(21) Application number: 23900756.0
(22) Date of filing: 08.12.2023
(51) Int. Cl.: H01L 21/20

(54) **SEMICONDUCTOR SUBSTRATE, MANUFACTURING METHOD AND MANUFACTURING APPARATUS FOR SEMICONDUCTOR SUBSTRATE, AND MANUFACTURING METHOD AND MANUFACTURING APPARATUS FOR SEMICONDUCTOR DEVICE**

(30) Priority: 09.12.2022 JP 2022197453
(71) Applicant: Kyocera Corporation, Kyoto-shi, Kyoto 612-8501 (JP)
(72) Inventor: HAYASHI, Yuichiro, Kyoto-shi, Kyoto 612-8501 (JP); TANIGUCHI, Yuki, Kyoto-shi, Kyoto 612-8501 (JP); MASAKI, Katsuaki, Kyoto-shi, Kyoto 612-8501 (JP); KAMIKAWA, Takeshi, Kyoto-shi, Kyoto 612-8501 (JP)
(74) Representative: Viering, Jentschura & Partner mbB Patent- und Rechtsanwälte
(86) International application number: PCT/JP2023/044088
(87) International publication number: WO 2024/122644

(57) **Abstract**

The present semiconductor substrate includes a ridge substrate including a ridge portion extending in a first direction and a first surface portion and a second surface portion being located lower than the ridge portion and adjacent to each other via the ridge portion, and a nitride semiconductor layer located on the ridge substrate, in which the nitride semiconductor layer includes a first tether portion located on the ridge portion, a first wing portion connected to the first tether portion in a state of floating off the first surface portion, and a first recessed portion located on the ridge portion and having a shape recessed with respect to the first tether portion.

## Description

### TECHNICAL FIELD

The present disclosure relates to a semiconductor substrate and the like.

### BACKGROUND OF INVENTION

Patent Document 1 discloses a method (ELO method) in which a mask pattern including a mask portion and an opening portion is formed on a base substrate including a seed layer, and a nitride semiconductor layer is laterally grown on the mask portion by using the seed layer exposed in the opening portion as a growth starting point.

### CITATION LIST

### PATENT LITERATURE

Patent Document 1: JP 2013-251304 A

### SUMMARY

A semiconductor substrate according to the present disclosure includes a ridge substrate including a ridge portion extending in a first direction and a first surface portion and a second surface portion being located lower than the ridge portion and adjacent to each other via the ridge portion, and a nitride semiconductor layer located on the ridge substrate, in which the nitride semiconductor layer includes a first tether portion located on the ridge portion, a first wing portion connected to the first tether portion in a state of floating off the first surface portion, and a first recessed portion located on the ridge portion and having a shape recessed with respect to the first tether portion.

### BRIEF DESCRIPTION OF THE DRAWINGS

FIG. 1 is a plan view illustrating a configuration example of a semiconductor substrate according to the present embodiment.
FIG. 2 is examples of a cross-sectional view including a line a-a and a cross-sectional view including a line b-b in FIG. 1.
FIG. 3 is a cross-sectional view illustrating a configuration example of a first tether portion.
FIG. 4 is a cross-sectional view illustrating a configuration example of a first wing portion.
FIG. 5 is a cross-sectional view illustrating a configuration example of the first wing portion.
FIG. 6 is other examples of the cross-sectional views taken along the line a-a and the cross-sectional view taken along the line b-b in FIG. 1.
FIG. 7 is a flowchart illustrating a manufacturing method for a semiconductor substrate according to the present embodiment.
FIG. 8 is cross-sectional views each illustrating the manufacturing method for a semiconductor substrate according to the present embodiment.
FIG. 9 is a block diagram illustrating the manufacturing apparatus for a semiconductor substrate according to the present embodiment.
FIG. 10 is cross-sectional views each illustrating another manufacturing method for a semiconductor substrate according to the present embodiment.
FIG. 11 is a plan view illustrating a configuration example of a semiconductor substrate according to the present embodiment.
FIG. 12 is cross-sectional views each illustrating a configuration example of the semiconductor substrate according to the present embodiment.
FIG. 13 is a plan view illustrating an example of separating a tether portion and a wing portion from each other.
FIG. 14 is cross-sectional views each illustrating an example of separating the tether portion and the wing portion from each other.
FIG. 15 is cross-sectional views each illustrating an example of separating the tether portion and the wing portion from each other.
FIG. 16 is a cross-sectional view illustrating a configuration example of a semiconductor device.
FIG. 17 is a top view illustrating a configuration example of the semiconductor device.
FIG. 18 is a plan view illustrating a configuration example of a semiconductor substrate according to the present embodiment.
FIG. 19 is cross-sectional views each illustrating a configuration example of the semiconductor substrate according to the present embodiment.
FIG. 20 is a plan view illustrating an example of separating the tether portion and the wing portion from each other.
FIG. 21 is cross-sectional views each illustrating an example of separating the tether portion and the wing portion from each other.
FIG. 22 is a flowchart illustrating a manufacturing method for a semiconductor device according to the present embodiment.
FIG. 23 is cross-sectional views each illustrating the manufacturing method for a semiconductor device according to the present embodiment.
FIG. 24 is a block diagram illustrating the manufacturing apparatus for a semiconductor device according to the present embodiment.
FIG. 25 is a flowchart illustrating a manufacturing method for a semiconductor device according to the present embodiment.
FIG. 26 is cross-sectional views each illustrating a manufacturing method for a semiconductor device according to the present embodiment.
FIG. 27 is a block diagram illustrating the manufacturing apparatus for a semiconductor device according to the present embodiment.
FIG. 28 is a plan view illustrating a configuration example of a semiconductor substrate according to the present embodiment.
FIG. 29 is a plan view illustrating a configuration example of a semiconductor substrate according to the present embodiment.
FIG. 30 is a plan view illustrating a configuration example of a semiconductor substrate according to the present embodiment.
FIG. 31 is plan views each illustrating a configuration example of a semiconductor substrate according to the present embodiment.
FIG. 32A is a plan view illustrating a configuration example of a semiconductor substrate according to the present embodiment.
FIG. 32B is a plan view illustrating a configuration example of a semiconductor substrate according to the present embodiment.
FIG. 33 is plan views each illustrating a configuration example of a semiconductor substrate according to the present embodiment.
FIG. 34 is a plan view illustrating a configuration example of a semiconductor substrate according to the present embodiment.
FIG. 35 is plan views each illustrating a configuration example of a semiconductor substrate according to the present embodiment.
FIG. 36 is a plan view illustrating a configuration example of a semiconductor substrate according to the present embodiment.
FIG. 37 is a plan view illustrating a configuration example of a semiconductor substrate according to the present embodiment.
FIG. 38 is cross-sectional views each illustrating a configuration example of a ridge substrate.
FIG. 39 is a plan view illustrating a configuration example of a semiconductor substrate according to the present embodiment.
FIG. 40 is examples of a cross-sectional view taken along a line a-a and a cross-sectional view taken along a line b-b in FIG. 39.

### DESCRIPTION OF EMBODIMENTS

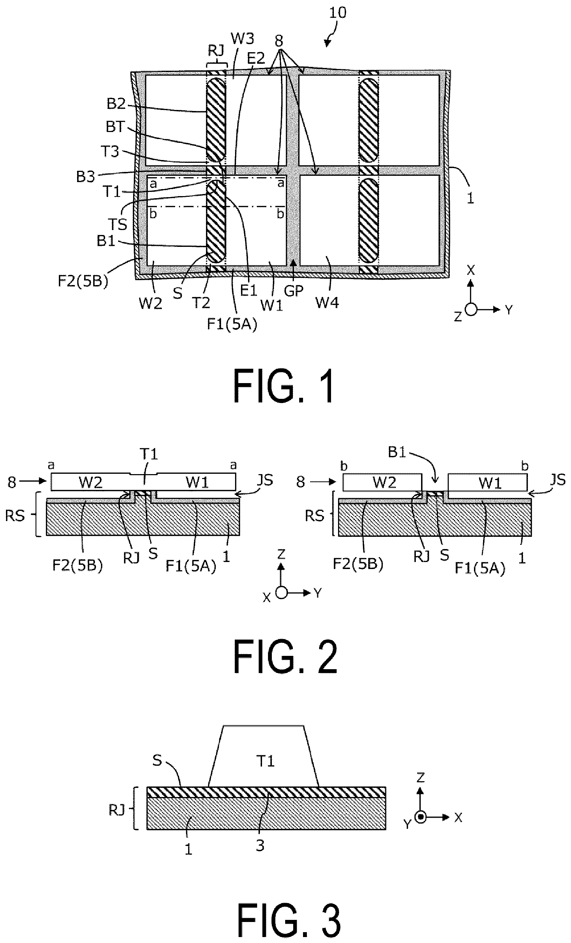

FIG. 1 is a plan view illustrating a configuration example of a semiconductor substrate according to the present embodiment. FIG. 2 is examples of a cross-sectional view including a line a-a and a cross-sectional view including a line b-b in FIG. 1. As illustrated in FIGs. 1 and 2, a semiconductor substrate 10 includes a ridge substrate RS including a ridge portion RJ extending in a first direction X and a first surface portion F1 and a second surface portion F2, which are located lower than the ridge portion RJ and adjacent to each other via the ridge portion RJ, and a nitride semiconductor layer 8 located on the ridge substrate RS, and the nitride semiconductor layer 8 includes a first tether portion T1 located on the ridge portion RJ, a first wing portion W1 connected to the first tether portion T1 in a state of floating off the first surface portion F1, and a first recessed portion B1 located on the ridge portion RJ and having a shape recessed with respect to the first tether portion T1. A direction from the ridge substrate RS toward the nitride semiconductor layer 8 is referred to as "upward", and a position above an object is referred to as a higher position than the object.

In the semiconductor substrate 10, an internal stress in the first wing portion W1 can be reduced by keeping the first wing portion W1 floating off the first front surface portion F1 (keeping the first wing portion W1 away from the first front surface portion F1), and an internal stress on the ridge portion RJ of the nitride semiconductor layer 8 can be reduced by the first recessed portion B1. Thus, warp of the semiconductor substrate 10 including the nitride semiconductor layer 8 can be reduced.

Since the nitride semiconductor layer 8 includes the first tether portion T1 and the first recessed portion B1, a contact surface area between the nitride semiconductor layer 8 and the ridge substrate RS can be reduced, and the nitride semiconductor layer 8 can be easily peeled off from the ridge substrate RS. To be more specific, since the first wing portion W1 is away from the first surface portion F1, the contact surface area between the nitride semiconductor layer 8 and the ridge substrate RS can be further reduced, and the first wing portion W1 can be easily peeled off from the ridge substrate RS. Since the first tether portion T1 and the first recessed portion B1 are located on the ridge portion RJ, the first tether portion T1 can be formed without etching the first wing portion W1 having less internal stress. As compared with a case in which the first wing portion W1 is etched, the ease of peeling off of the first wing portion W1 can be increased while ensuring the width of the first wing portion W1 having less internal stress.

The ridge substrate RS may include a main substrate 1 having a lattice constant different from that of the nitride semiconductor layer 8. The nitride semiconductor layer 8 may contain a GaN-based semiconductor, and the main substrate 1 may be a silicon substrate or a silicon carbide substrate.

The nitride semiconductor layer 8 may include a second wing portion W2 connected to the first tether portion T1 in a state of floating off the second surface portion F2. The nitride semiconductor layer 8 may include a second tether portion T2 located on the ridge portion RJ and spaced apart from the first tether portion T1, and the first wing portion W1 may be connected to the second tether portion T2. With this configuration, the first wing portion W1 can be held by the first and second tether portions T1 and T2, so that the first wing portion W1 becomes more stable. Each of the first tether portion T1 and the second tether portion T2 may be connected to a corresponding one of both end portions of the first wing portion W1 facing each other in the first direction X, and the first recessed portion B1 may be located between the first tether portion T1 and the second tether portion T2. A size of the first tether portion T1 in the first direction X may be one fourth or less a size of the first wing portion W1 in the first direction X. This makes it easy to separate the first tether portion T1 and the first wing portion W1 from each other.

A boundary BT between the first tether portion T1 and the first recessed portion B1 may be located in the vicinity of an end portion of the first wing portion W1. Thus, when a tape or a support substrate is pressed against a surface of the semiconductor substrate 10 to peel off the first wing portion W1 as will be described later, a separation plane (for example, a cleavage plane) can be easily formed at the end portion of the first wing portion W1. Here, the vicinity of the end portion of the first wing portion W1 may be, for example, a region from 1 µm to 10 µm from the end portion of the first wing portion W1.

An upper surface of the ridge portion RJ may be a seed region S serving as a starting point of crystal growth of the nitride semiconductor layer 8. In the semiconductor substrate 10, a bottom of the first recessed portion B1 may reach the ridge portion RJ, or the seed region S may be exposed at the bottom of the first recessed portion B1. The ridge portion RJ may include a seed portion including a nitride semiconductor (for example, a GaN semiconductor or AlN), and the seed region S may be an upper surface of the seed portion.

The nitride semiconductor layer 8 contains a nitride semiconductor as a main content. The nitride semiconductor may be expressed by, for example, AlₓGa_{y}In_{z}N (O ≤ x ≤ 1; 0 ≤ y ≤ 1; 0 ≤ z ≤ 1; x + y + z = 1). Specific examples of the nitride semiconductor include a GaN-based semiconductor, aluminum nitride (AlN), indium aluminum nitride (InAlN), and indium nitride (InN). The GaN-based semiconductor is a semiconductor containing gallium atoms (Ga) and nitrogen atoms (N). Typical examples of the GaN-based semiconductor include GaN, AlGaN, AlGaInN, and InGaN.

The nitride semiconductor layer 8 may be a doped type (for example, n-type including a donor) or a non-doped type. The semiconductor substrate means a substrate containing a semiconductor, and the main substrate 1 of the ridge substrate RS may contain a semiconductor (for example, silicon or silicon carbide), or does not need to contain a semiconductor. Examples of the main substrate 1 that does not contain a semiconductor include a sapphire substrate. The ridge substrate RS may be referred to as a template substrate or a growth substrate. In the ridge substrate RS, part of the main substrate 1 may be included in the ridge portion RJ.

The first direction X may be an m-axis direction (<1-100> direction) of the nitride semiconductor layer 8. A second direction Y may be an a-axis direction (<11-20> direction) of the nitride semiconductor layer 8. A thickness direction (third direction Z) of the nitride semiconductor layer 8 may be a c-axis direction (<0001> direction) of the nitride semiconductor layer 8, and a height direction in the semiconductor substrate 10 may be parallel to the c-axis. Viewing an object with a line of sight parallel to a normal direction (third direction Z) of the semiconductor substrate 10 (including viewing an object in a perspective manner) is referred to as "plan view".

The nitride semiconductor layer 8 can be formed by an epitaxial lateral overgrowth (ELO) method with the upper surface of the ridge portion RJ (seed region S) as a starting point. By forming the first wing portion W1 extending in the lateral direction (second direction Y) from the base portion (vertical growth layer) grown on the ridge portion RJ, separated from the first surface portion F1, and located on a void space, the first wing portion W1 that has a wide width, a low defect density and high flatness can be obtained.

The first and second tether portions T1 and T2 of the nitride semiconductor layer 8 located above the ridge portion RJ may be dislocation inheritance portions having a large number of threading dislocations, and the first and second wing portions W1 and W2 may be low-defect portions having a threading dislocation density lower than that of the dislocation inheritance portions.

The nitride semiconductor layer 8 may include a third wing portion W3 spaced apart from the first wing portion W1 in the first direction X in a state of floating off the first surface portion F1. The nitride semiconductor layer 8 may include a third tether portion T3 located on the ridge portion RJ and spaced apart from the first tether portion T1, and the third wing portion W3 may be connected to the third tether portion T3. The nitride semiconductor layer 8 may include a third recessed portion B3 located between the first tether portion T1 and the third tether portion T3 and having a shape recessed with respect to the first tether portion T1. The nitride semiconductor layer 8 may include a fourth wing portion W4 spaced apart from the first wing portion W1 in the second direction Y in a state of floating off the first surface portion F1. The first wing portion W1 and the fourth wing portion W4 may be adjacent to each other via a gap GP.

In the semiconductor substrate 10, each of the first front surface portion F1 and the second front surface portion F2 may have a growth suppressing function. The first surface portion F1 may be a first mask portion 5A, the second surface portion F2 may be a second mask portion 5B, and the first wing portion W1 may be located over the first mask portion 5A via a hollow portion JD. A side surface of the ridge portion RJ may have a growth suppressing function.

A thickness of the first tether portion T1 may be smaller than a thickness of the first wing portion W1. A ratio of a surface area of the first wing portion W1 to a surface area of the first tether portion T1 may be 10 or more. A curved surface TS may be included in a side surface of the first tether portion T1, and the curved surface TS may be included in an inner wall of the first recessed portion B1.

Hereinafter, the first to fourth wing portions W1 to W4 may be collectively referred to as a wing portion W, the first to third tether portions T1 to T3 may be collectively referred to as a tether T, and the first and second mask portions 5A and 5B may be collectively referred to as a mask portion 5.

FIG. 3 is a cross-sectional view illustrating a configuration example of the first tether portion. The first recessed portion B1 and the first tether portion T1 can be formed by patterning a vertical growth layer (base portion) crystal grown on the ridge portion RJ. As illustrated in FIG. 3, the first tether portion T1 may have a tapered shape of an upwardly narrowing type.

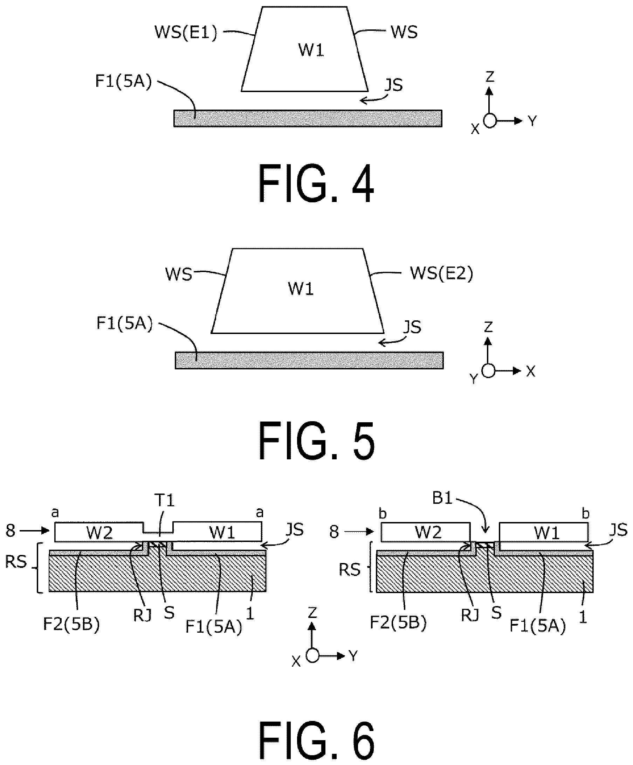

FIGs. 4 and 5 are cross-sectional views each illustrating a configuration example of the first wing portion. As illustrated in FIGs. 1, 4 and 5, the first wing portion W1 may include a first edge E1 connected to the first tether portion T1 and extending in the first direction X. The first wing portion W1 may include a second edge E2 connected to the first tether portion T1 and extending in the second direction Y orthogonal to the first direction X. The first and second edges E1 and E2 can be formed by patterning the nitride semiconductor layer 8, and a tapered surface WS of an upwardly narrowing type may be included in the first wing portion W1.

FIG. 6 is other examples of the cross-sectional views taken along the line a-a and the cross-sectional view taken along the line b-b in FIG. 1. In FIG. 2, the bottom of the first recessed portion B1 reaches the ridge portion RJ (the first recessed portion B1 is an opening penetrating the nitride semiconductor layer 8), but the present embodiment is not limited to this. As illustrated in FIG. 6, the bottom of the first recessed portion B1 need not reach the ridge portion RJ (the first recessed portion B1 does not penetrate the nitride semiconductor layer 8).

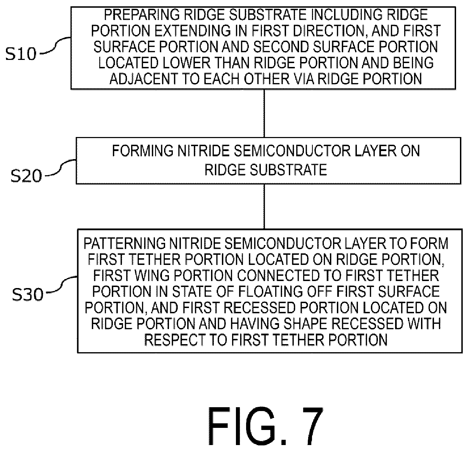

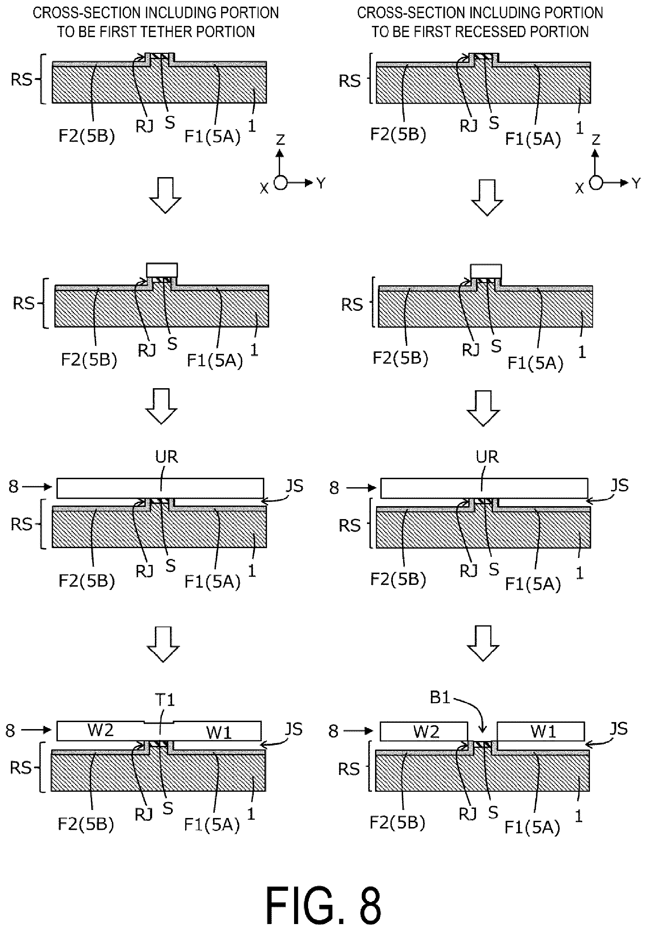

FIG. 7 is a flowchart illustrating a manufacturing method for a semiconductor substrate according to the present embodiment. FIG. 8 is cross-sectional views each illustrating the manufacturing method for a semiconductor substrate according to the present embodiment. As illustrated in FIGs. 7 and 8, the manufacturing method for a semiconductor substrate according to the present embodiment includes step S10 of forming the ridge substrate RS including the ridge portion RJ extending in a first direction X and the first and the second surface portions F1 and F2, which are located lower than the ridge portion RJ and adjacent to each other via the ridge portion RJ, step S20 of forming the nitride semiconductor layer 8 on the ridge substrate RS, and step S30 of patterning the nitride semiconductor layer 8 by using, for example, dry etching and forming the first tether portion T1 located on the ridge portion RJ, the first wing portion W1 connected to the first tether portion T1 in a state of floating off the first surface portion F1, and the first recessed portion B1 located on the ridge portion RJ and having a shape recessed with respect to the first tether portion T1.

The ELO method may be used for step S20, and the growth of the nitride semiconductor layer 8 may be stopped in a state where the first and fourth wing portions W1 and W4 growing in directions approaching each other (parallel to the second direction Y) do not meet each other (the gap GP is formed). In step S30, the first recessed portion B1 and the first tether portion T1 may be formed by patterning a base portion UR (vertical growth layer) crystal grown on the ridge portion RJ. For example, a portion of the base portion UR that is not covered with a resist and is etched may be the first recessed portion B1, and a portion of the base portion UR that is covered with the resist and is not etched may be the first tether portion T1. A dry etching method can be used for etching the nitride semiconductor layer 8. The second recessed portion B2, the third recessed portion B3, and a gap (separation groove) between the first and third wing portions W1 and W3 may be formed in step S30.

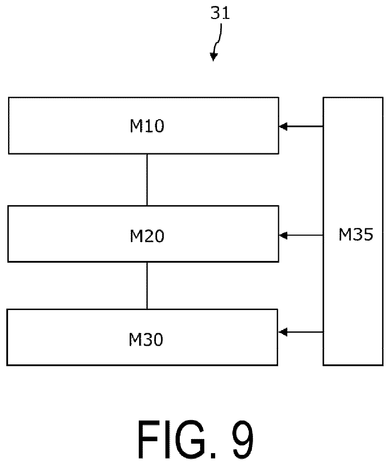

FIG. 9 is a block diagram illustrating the manufacturing apparatus for a semiconductor substrate according to the present embodiment. A manufacturing apparatus 31 for a semiconductor substrate includes an apparatus M10 for performing step S10 illustrated in FIG. 7, an apparatus M20 for performing step S20 illustrated in FIG. 7, an apparatus M30 for performing step S30 illustrated in FIG. 7, and an apparatus M35 for controlling the apparatuses M10, M20, and M30. The apparatus M20 may be an MOCVD apparatus.

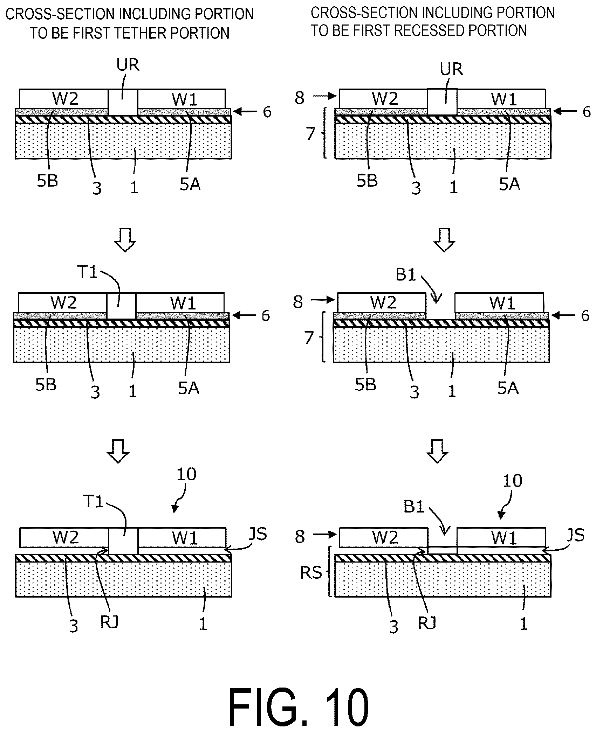

FIG. 10 is cross-sectional views each illustrating another manufacturing method for a semiconductor substrate according to the present embodiment. As illustrated in FIG. 10, the semiconductor substrate 10 may be formed by forming the nitride semiconductor layer 8 in contact with a mask pattern 6 on the template substrate 7 in which the seed portion 3 and the mask pattern 6 (including the first and second mask portions 5A and 5B and the opening portion for exposing the seed portion 3) are formed on the main substrate 1, then forming the first recessed portion B1 and the first tether portion T1 in the base portion UR (vertical growth layer) grown on the opening portion of the mask pattern 6 by patterning the nitride semiconductor layer 8, and then removing the mask pattern 6.

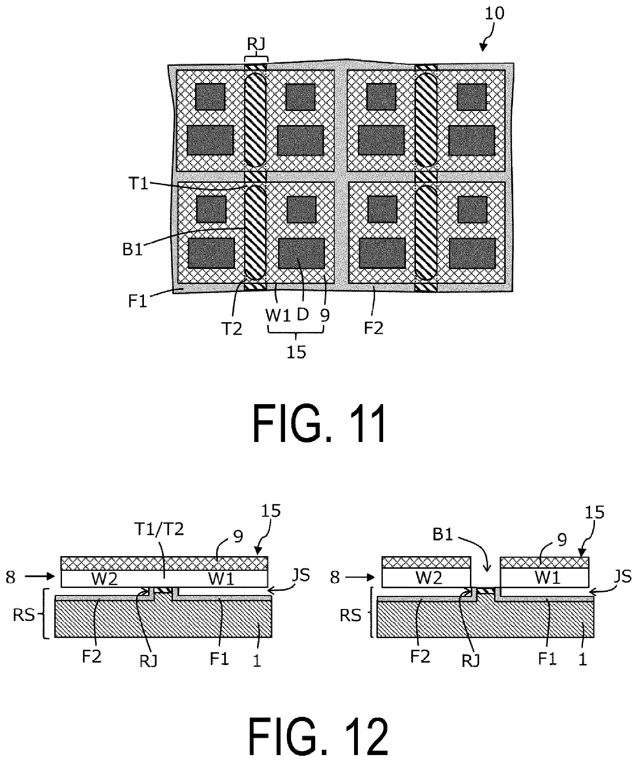

FIG. 11 is a plan view illustrating a configuration example of a semiconductor substrate according to the present embodiment. FIG. 12 is cross-sectional views each illustrating a configuration example of the semiconductor substrate according to the present embodiment. As illustrated in FIGs. 11 and 12, the semiconductor substrate 10 may include a functional layer 9 located on the nitride semiconductor layer 8 and including an active layer, and the functional layer 9 may be located on the first wing portion W1. An electrode D may be located on the functional layer 9. The functional layer 9 may be located on the first tether portion T1, and the first tether portion T1 and the functional layer 9 may overlap each other in plan view. The functional layer 9 may include the active layer and a p-type layer. When the nitride semiconductor layer 8 and the functional layer 9 are formed above the ridge substrate RS, and then the nitride semiconductor layer 8 and the functional layer 9 are patterned to form the first recessed portion B1 and the first tether portion T1, the first recessed portion B1 need not overlap the functional layer 9 in plan view as illustrated in FIGs. 11 and 12.

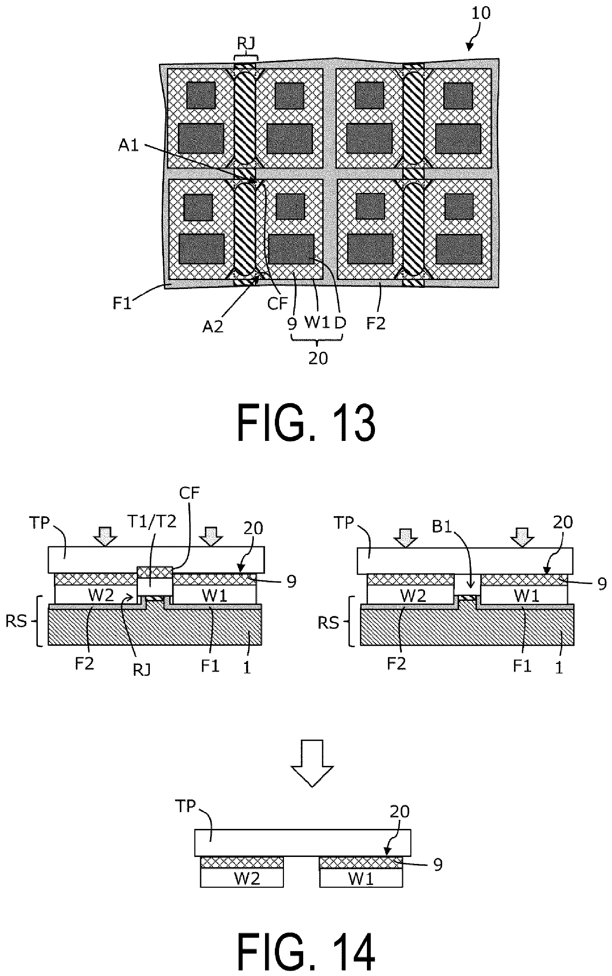

FIG. 13 is a plan view illustrating an example of separating a tether portion and a wing portion from each other. FIG. 14 is cross-sectional views each illustrating an example of separating the tether portion and the wing portion from each other. As illustrated in FIGs. 11 to 14, in a laminate body 15 including the first wing portion W1, the functional layer 9, and the electrodes D, each of an adjacent portion A1 adjacent to the first tether portion T1 and an adjacent portion A2 adjacent to the second tether portion T2 are broken, so that the first wing portion W1 can be separated from the first and second tether portions T1 and T2 and the laminate body 15 can be singulated as a semiconductor device 20 (semiconductor chip). For example, when a tape TP is pressed against the surface of the semiconductor substrate 10, the adjacent portions A1 and A2 are broken at a plane CF parallel to an m-plane of the nitride semiconductor layer 8, and the semiconductor device 20 can be transferred to the tape TP as illustrated in FIG. 14. At this time, by setting the cleavage plane to the m-plane, the possibility of generation of debris due to cleavage is reduced, and a transfer yield can be increased.

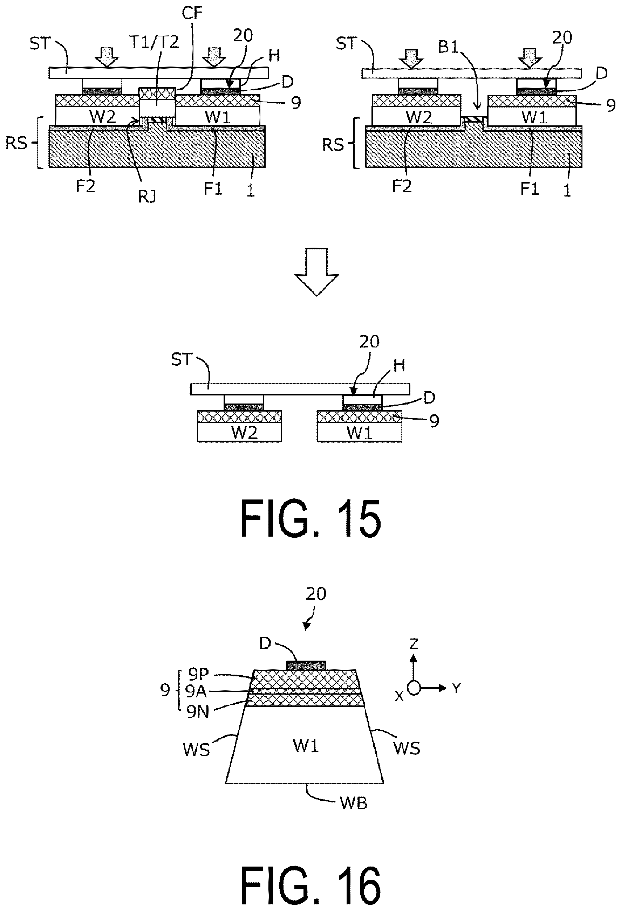

FIG. 15 is cross-sectional views each illustrating an example of separating the tether portion and the wing portion from each other. As illustrated in FIG. 15, the electrode D of the semiconductor substrate 10 is bonded to a support substrate ST (for example, a sub-mount substrate) via a metal layer (for example, a solder layer) H, and then the support substrate ST is pressed downward (pressed against the semiconductor substrate 10), so that the adjacent portions A1 and A2 are broken at the plane CF parallel to the m-plane of the nitride semiconductor layer 8, and the semiconductor device 20 can be transferred to the support substrate ST as illustrated in FIG. 15. In this case, selective transfer may be performed to selectively transfer only the laminate body 15 including the first wing portion W1 among a plurality of the laminate bodies 15 each including a plurality of the wing portions W.

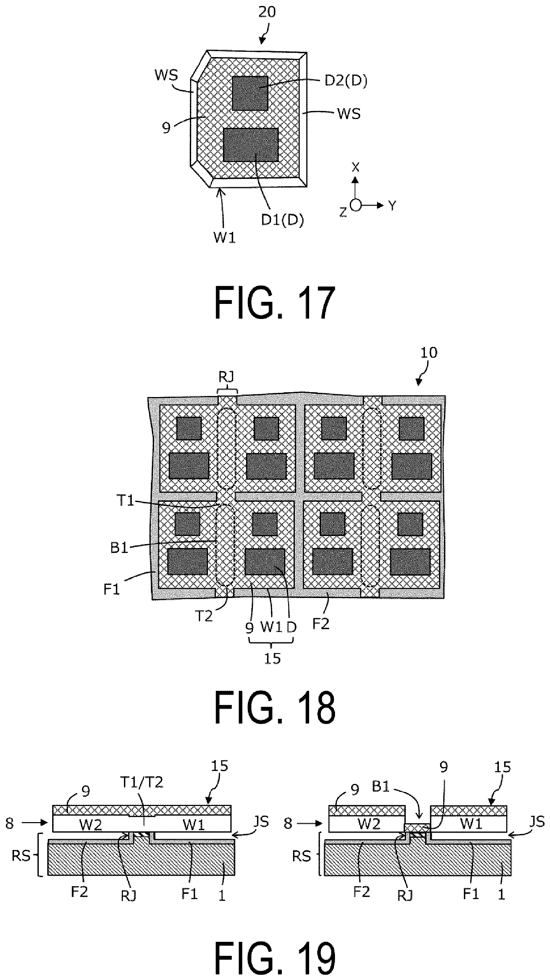

FIG. 16 is a cross-sectional view illustrating a configuration example of a semiconductor device. FIG. 17 is a top view illustrating a configuration example of the semiconductor device. As illustrated in FIGs. 16 and 17, the semiconductor device 20 may include the first wing portion W1, the functional layer 9, and electrodes D1 and D2. The functional layer 9 may include an n-type layer 9N, an active layer 9A, and a p-type layer 9P. The n-type layer 9N may include an n-type GaN-based semiconductor, and the p-type layer 9P may contain a p-type GaN-based semiconductor. The active layer 9A may have a quantum-well structure. When the semiconductor device 20 is a light-emitting element (for example, an LED element or a laser element), the first wing portion W1 is formed in a tapered shape including the tapered surface WS, so that light can be efficiently extracted to a back surface WB (surface opposite to a surface on which the electrode D is located). In the semiconductor device 20, the electrode D1 may be an anode and the electrode D2 may be a cathode.

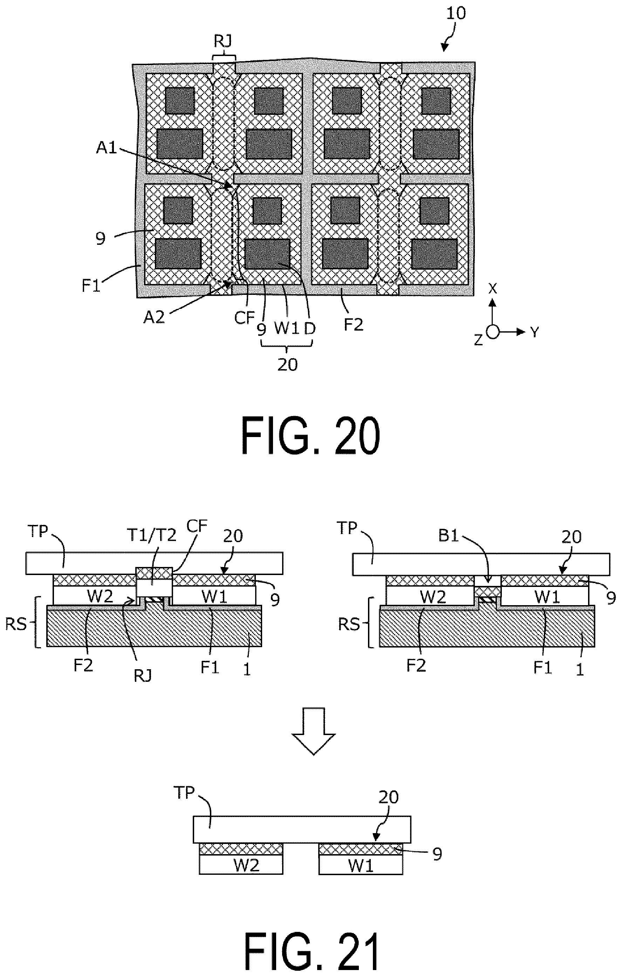

FIG. 18 is a plan view illustrating a configuration example of a semiconductor substrate according to the present embodiment. FIG. 19 is cross-sectional views each illustrating a configuration example of the semiconductor substrate according to the present embodiment. FIG. 20 is a plan view illustrating an example of separating the tether portion and the wing portion from each other. FIG. 21 is cross-sectional views each illustrating an example of separating the tether portion and the wing portion from each other. When the nitride semiconductor layer 8 is formed above the ridge substrate RS, then the nitride semiconductor layer 8 is patterned to form the first recessed portion B1 and the first tether portion T1, and then the functional layer 9 is formed, the first recessed portion B1 may overlap the functional layer 9 in plan view as illustrated in FIGs. 18 and 19. The functional layer 9 may be located on the first tether portion T1, and the first tether portion T1 and the functional layer 9 may overlap each other in plan view.

As illustrated in FIGs. 18 to 21, in the laminate body 15 including the first wing portion W1, the functional layer 9, and the electrodes D, each of the adjacent portion A1 adjacent to the first tether portion T1 and the adjacent portion A2 adjacent to the second tether portion T2 are broken, so that the first wing portion W1 can be separated from the first and second tether portions T1 and T2 and the laminate body 15 can be singulated as the semiconductor device 20 (semiconductor chip). For example, when the tape TP is pressed against the surface of the semiconductor substrate 10, the adjacent portions A1 and A2 are broken at the plane CF (for example, a cleavage plane) parallel to the m-plane of the nitride semiconductor layer 8, and the semiconductor device 20 can be transferred to the tape TP as illustrated in FIG. 21.

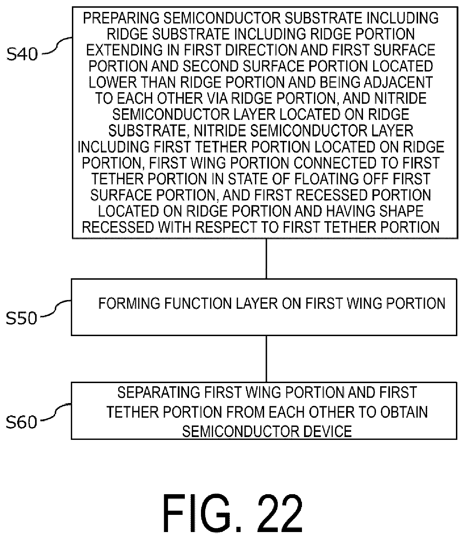

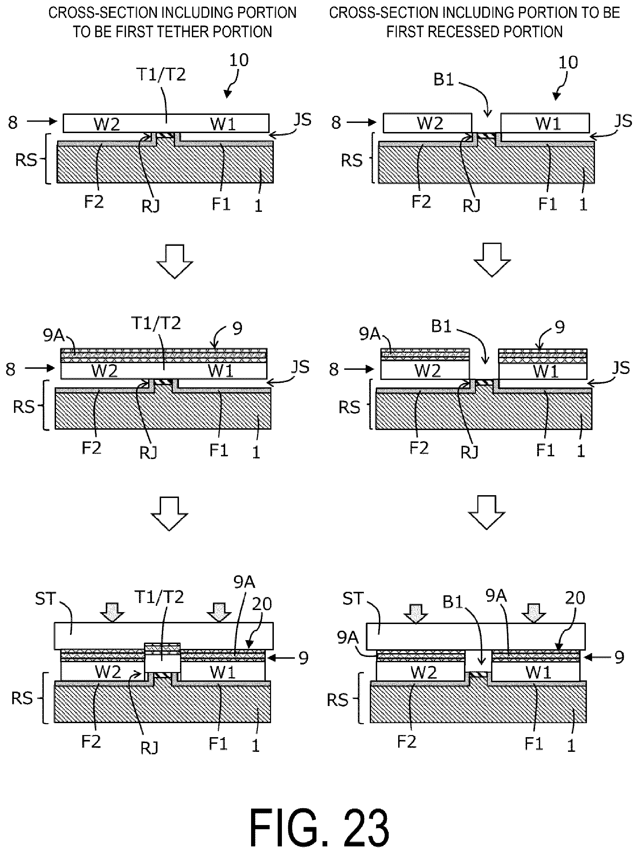

FIG. 22 is a flowchart illustrating a manufacturing method for a semiconductor device according to the present embodiment. FIG. 23 is cross-sectional views each illustrating the manufacturing method for a semiconductor device according to the present embodiment. As illustrated in FIGs. 22 and 23, the manufacturing method for a semiconductor device according to the present embodiment includes step S40 of preparing the semiconductor substrate 10 including the ridge substrate RS including the ridge portion RJ extending in the first direction X and the first surface portion F1 and the second surface portion F2, which are located lower than the ridge portion RJ and adjacent to each other via the ridge portion RJ, and the nitride semiconductor layer 8 located on the ridge substrate RS, the nitride semiconductor layer 8 including the first tether portion T1 located on the ridge portion RJ, the first wing portion W1 connected to the first tether portion T1 in a state of floating off the first surface portion F1, a first recessed portion B1 located on the ridge portion RJ and having a shape recessed with respect to the first tether portion T1, step S50 of forming the functional layer 9 including the active layer 9A on the first wing portion W1, and step S60 of separating the first wing portion W1 and the first tether portion T1 from each other to obtain the semiconductor device 20.

In step S50, the functional layer 9 (including, for example, the active layer 9A having a quantum-well structure) can be formed on the first wing portion W that is substantially free of strain, and thus the quality of the functional layer 9 is enhanced, which is advantageous. In step S50, a tape for transfer can be used in addition to the support substrate ST (see FIG. 23) such as a sub-mount. Step S60 may be performed after preparing the semiconductor substrate 10 (including the first tether portion T1, the first recessed portion B 1, and the functional layer 9) obtained by steps S40 and S50.

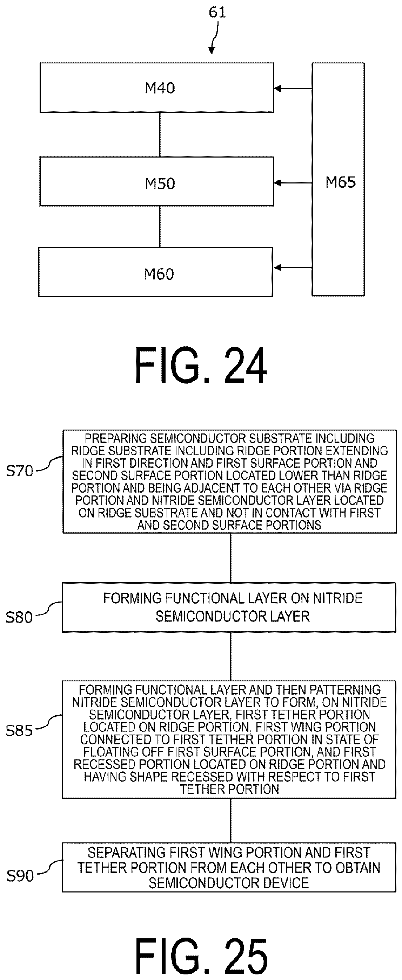

FIG. 24 is a block diagram illustrating the manufacturing apparatus for a semiconductor device according to the present embodiment. A manufacturing apparatus 61 for a semiconductor device may include an apparatus M40 for performing step S40, an apparatus M50 for performing step S50, an apparatus M60 for performing step S60, each illustrated in FIG. 22 and an apparatus M65 for controlling the apparatuses M40, M50, and M60.

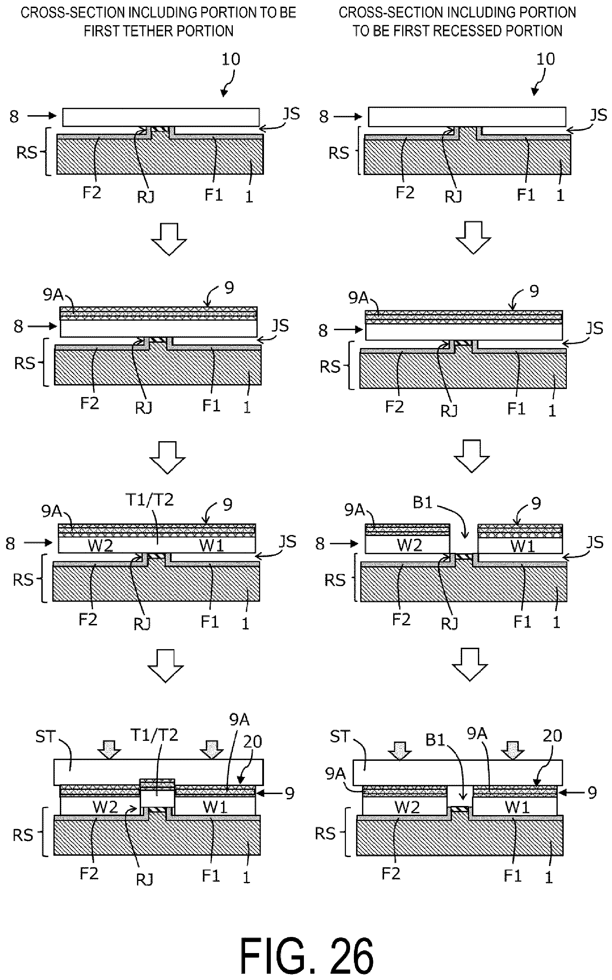

FIG. 25 is a flowchart illustrating a manufacturing method for a semiconductor device according to the present embodiment. FIG. 26 is cross-sectional views each illustrating a manufacturing method for a semiconductor device according to the present embodiment. As illustrated in FIGs. 25 and 26, the manufacturing method for a semiconductor device according to the present embodiment may include step S70 of preparing the semiconductor substrate 10 including the ridge substrate RS including the ridge portion RJ extending in the first direction X and the first surface portion F1 and the second surface portion F2, which are located lower than the ridge portion RJ and adjacent to each other via the ridge portion RJ, and the nitride semiconductor layer 8 located on the ridge substrate RS and not in contact with the first and second surface portions F1 and F2 (facing the first and second surface portions F1 and F2 via a hollow portion JS), step S80 of forming the functional layer 9 (including the active layer 9A, for example) on the nitride semiconductor layer 8, step S85 of forming the functional layer 9 and then patterning the nitride semiconductor layer 8, and forming, in the nitride semiconductor layer 8, the first tether portion T1 located on the ridge portion RJ, the first wing portion W1 connected to the first tether portion T1 in a state of floating off the first surface portion F1, and the first recessed portion B1 located on the ridge portion RJ and having a shape recessed with respect to the first tether portion T1, and step S90 of separating the first wing portion W1 and the first tether portion T1 from each other to obtain the semiconductor device 20.

As described above, the nitride semiconductor layer 8 and the functional layer 9 are formed above the ridge substrate RS, and then the nitride semiconductor layer 8 and the functional layer 9 are patterned to form the first recessed portion B1 and the first tether portion T1, and thus the nitride semiconductor layer 8 and the functional layer 9 (containing the nitride semiconductor layer) can be continuously formed, which is advantageous. The gap between the first and third wing portions W1 and W3 may be formed in step S85. In step S90, a tape for transfer can be used in addition to the support substrate ST (see FIG. 26) such as a sub-mount. Step S90 may be performed after preparing the semiconductor substrate 10 (including the first tether portion T1, the first recessed portion B1, and the functional layer 9) obtained by steps S70, S80, and S85.

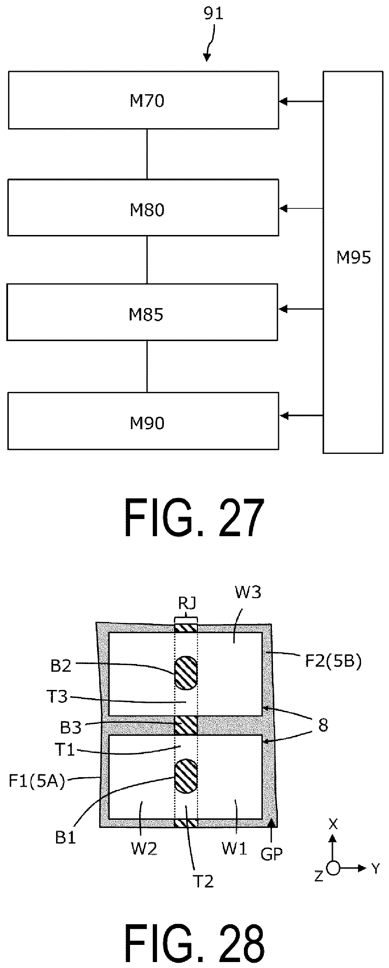

FIG. 27 is a block diagram illustrating the manufacturing apparatus for a semiconductor device according to the present embodiment. A manufacturing apparatus 91 for a semiconductor device may include an apparatus M70 for performing step S70, an apparatus M80 for performing step S80, an apparatus M85 for performing step S85, an apparatus M90 for performing step S90 each illustrated in FIG. 25, and an apparatus M95 for controlling the apparatuses M70, M80, M85, and M90.

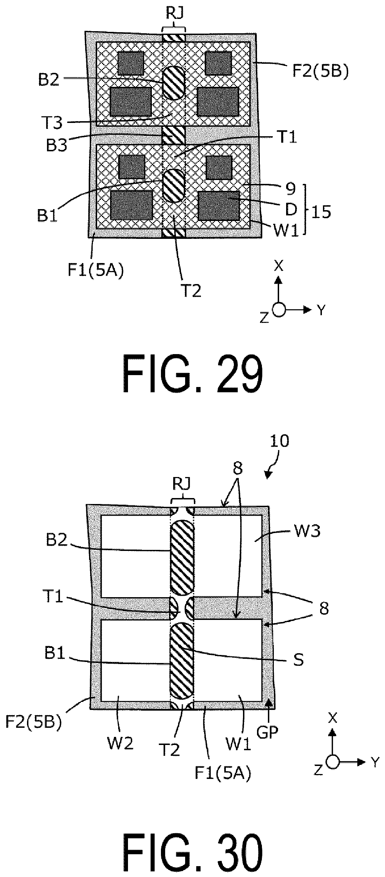

FIGs. 28 and 29 are plan views each illustrating a configuration example of a semiconductor substrate according to the present embodiment. As in the semiconductor substrate 10 of FIG. 28, the sizes of the first and second tether portions T1 and T2 in the first direction X may be one fourth or more the size of the first wing portion W1 in the first direction X, and the first recessed portion B1 having a circular opening may be located between the first and second tether portions T1 and T2. As illustrated in FIG. 28, the functional layer 9 and the electrode D may be located on the first wing portion W1, and the functional layer 9 may be located on the first tether portion T1. In this case, a portion of the first wing portion W1 adjacent to the first tether portion T1 and a portion of the first wing portion W1 adjacent to the second tether portion T2 are broken, so that the first wing portion w1 and the first and second tether portions T1 and T2 can be separated from each other, and the laminate body 15 including the first wing portion W1, the functional layer 9, and the electrode D can be singulated as the semiconductor device 20.

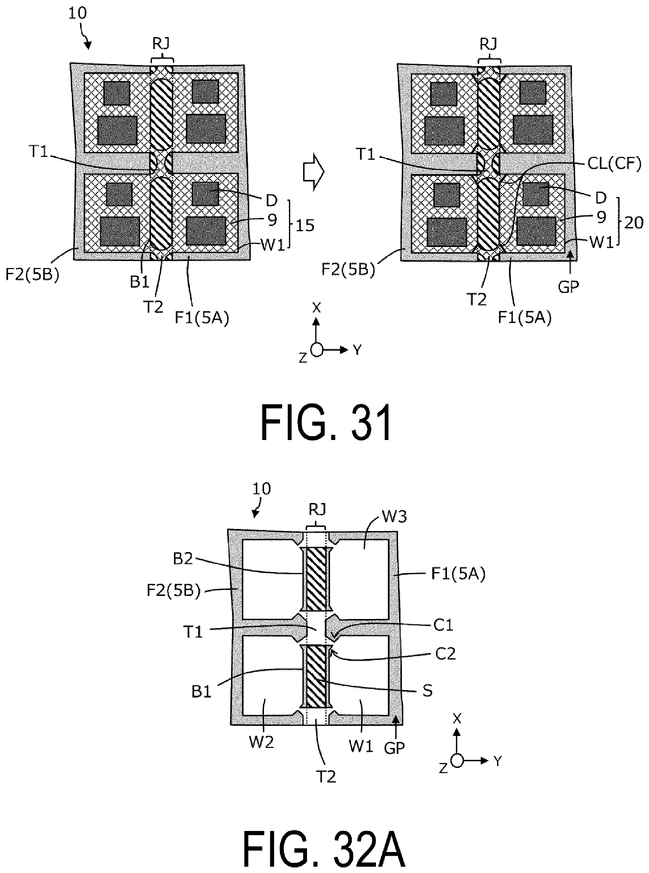

FIGs. 30 and 31 are plan views each illustrating a configuration example of a semiconductor substrate according to the present embodiment. As in the semiconductor substrate 10 of FIG. 30, the nitride semiconductor layer 8 may include the third wing portion W3 spaced apart from the first wing portion W1 in the first direction X in a state of floating off the first surface portion F1, and the third wing portion W3 may be connected to the first tether portion T1. In this case, a portion of the first wing portion W1 adjacent to the first tether portion T1 and a portion of the first wing portion W1 adjacent to the second tether portion T2 are broken, so that the first wing portion w1 and the first and second tether portions T1 and T2 can be separated from each other, and the laminate body 15 including the first wing portion W1, the functional layer 9, and the electrode D can be singulated as the semiconductor device 20.

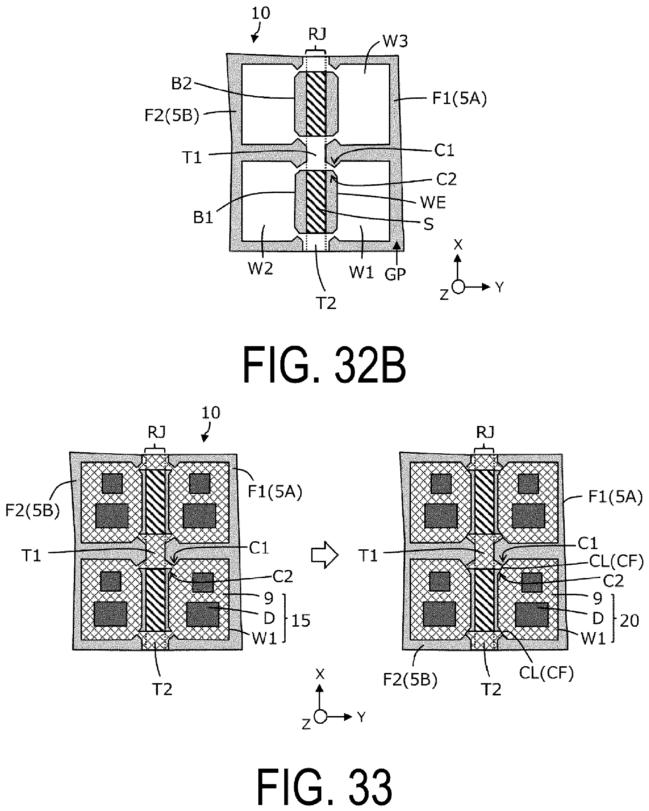

FIGs. 32A, 32B, and 33 are plan views each illustrating a configuration example of a semiconductor substrate according to the present embodiment. As illustrated in FIGs. 32A and 33, the first wing portion W1 may include a first notch portion C1 adjacent to the first tether portion T1. The first wing portion W1 may include first and second notch portions C1 and C2 each adjacent to the first tether portion T1, and a straight line CL connecting a frond end of the first notch portion C1 and a frond end of the second notch portion C2 may be oblique to the first direction X in plan view. The straight line CL may be parallel to the m-plane of the nitride semiconductor layer 8. In this case, the first wing portion W1 at the plane CF including the straight line CL adjacent to the first tether portion T1 and the plane CF including the straight line CL adjacent to the second tether portion T2 are broken, so that the first wing portion W1 and the first and second tether portions T1 and T2 can be separated from each other, and the laminate body 15 including the first wing portion W1, the functional layer 9, and the electrode D can be singulated as the semiconductor device 20.

As illustrated in FIG. 32B, a width (size in the second direction Y) of the first recessed portion B1 may be larger than a width of the ridge portion RJ. That is, the entire width of the ridge portion RJ may be exposed below the first recessed portion B1. Part of the first tether portion T1 may be floating off the ridge substrate RS. That is, there may be a void space between part of the first tether portion T1 and the ridge substrate RS (first surface portion F1). An inner periphery WE of the first wing portion W1 and the ridge portion RJ may be separated from each other in the second direction Y in plan view.

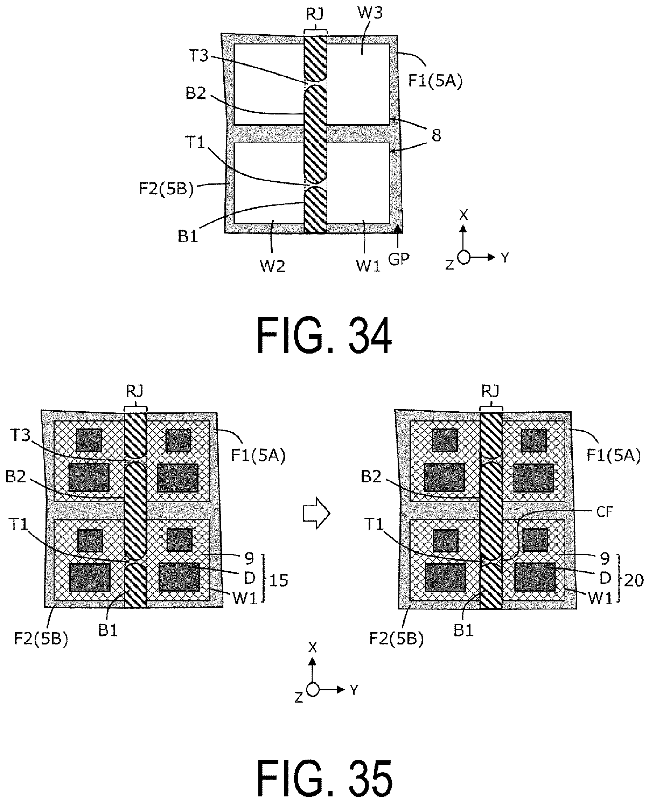

FIGs. 34 and 35 are plan views each illustrating a configuration example of a semiconductor substrate according to the present embodiment. As in the semiconductor substrate 10 of FIG. 34, the nitride semiconductor layer 8 may include a second recessed portion B2 located on the ridge portion RJ and having a shape recessed with respect to the first tether portion T1, and the first tether portion T1 may be located between the first recessed portion B1 and the second recessed portion B2. The first recessed portion B1 may be adjacent to the first wing portion W1 and the second wing portion W2 in plan view.

The first tether portion T1 may be connected to a central portion of the first wing portion W1 in the first direction X. The size of the first tether portion T1 in the first direction X may be one fourth or less the size of the first wing portion W1 in the first direction X. In this case, a portion of the first wing portion W1 adjacent to the first tether portion T1 is broken, so that the first wing portion W1 and the first tether portion T1 can be separated from each other, and the laminate body 15 including the first wing portion W1, the functional layer 9, and the electrode D can be singulated as the semiconductor device 20.

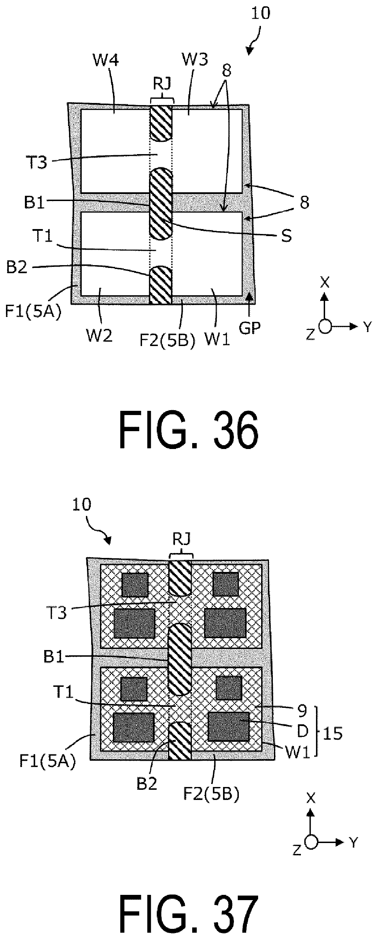

FIGs. 36 and 37 are plan views each illustrating a configuration example of a semiconductor substrate according to the present embodiment. As in the semiconductor substrate 10 of FIG. 36, the size of the first tether portion T1 in the first direction X may be more than one fourth the size of the first wing portion W1 in the first direction X. In this case, a portion of the first wing portion W1 adjacent to the first tether portion T1 is broken, so that the first wing portion W1 and the first tether portion T1 can be separated from each other, and the laminate body 15 including the first wing portion W1, the functional layer 9, and the electrode D can be singulated as the semiconductor device 20.

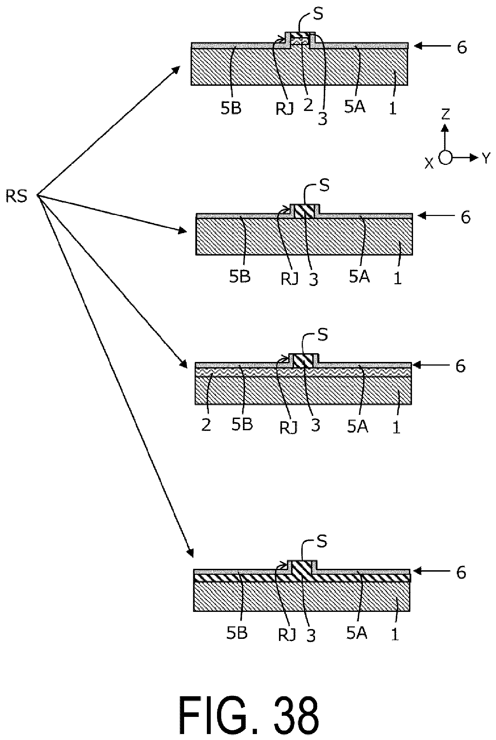

FIG. 38 is cross-sectional views each illustrating a configuration example of a ridge substrate. In the ridge substrate RS illustrated in FIG. 2 or the like, a buffer portion 2 may be formed between a protruding portion of the main substrate 1 and the seed portion 3. Although part (protruding portion) of the main substrate 1 is provided in the ridge portion RJ in FIG. 2 or the like, the configuration is not limited to this example. The seed portion 3 having a stripe shape may be formed on the main substrate 1 having a flat upper surface to serve as the ridge portion RJ, or the buffer portion 2 may be formed between the main substrate 1 and the seed portion 3 having the stripe shape. In this case, the upper surface of the seed portion 3 exposed from the mask pattern 6 becomes the seed region S. The seed portion 3 including a protruding portion having a stripe shape may be formed on the main substrate 1 having a flat upper surface to serve as the ridge portion RJ.

As the seed portion 3, a GaN-based semiconductor, AlN, or the like can be used. As the buffer portion 2, Al, AlN, SiC, or the like can be used. When a silicon substrate is used as the main substrate 1, it is desirable that the buffer portion 2 being in contact with the silicon substrate does not contain gallium in order to suppress melt back (silicon gallium melt).

The ridge substrate RS may include the main substrate 1 that is a heterogeneous substrate having a different lattice constant from that of the nitride semiconductor layer 8. A plane orientation of the main substrate 1 is, for example, the (111) plane of the silicon substrate, the (0001) plane of the sapphire substrate, or the 6H-SiC (0001) plane of the SiC substrate. These are merely examples, and any substrate and any plane orientation may be used as long as the nitride semiconductor layer 8 can be grown by the ELO method.

The mask pattern 6 includes the mask portion 5 (5A, 5B). The mask portion 5 may function as a selective growth mask (deposition suppression mask) for growing the nitride semiconductor layer 8 in the lateral direction.

Examples of the mask portion 5 that can be used include a single-layer film including any one of a silicon oxide film (SiOx), a titanium nitride film (TiN or the like), a silicon nitride film (SiNx), a silicon oxynitride film (SiON), and a metal film having a high melting point (for example, 1000°C or higher), and a laminate film including at least two thereof. A thermal oxide film obtained by obtained by performing thermal oxidation treatment on a silicon substrate, a silicon nitride substrate, or the like may be used as the mask portion 5. As the mask portion 5, a laminate film in which a silicon oxide film and a silicon nitride film are formed in this order can be used. An upper layer film in contact with the semiconductor layer 8 may be a silicon nitride film.

The nitride semiconductor layer 8 on the ridge substrate RS may be formed as follows, for example. In this example, the nitride semiconductor layer 8 was a GaN layer, a growth temperature was from 1000 decrees to 1200 degrees, a V/III ratio was from 500 to 20000, and a growth pressure was 50 kPa. Note that in order to make the nitride semiconductor layer 8 be an n-type, doping may be performed by flowing SiH₄. The film-forming conditions of the nitride semiconductor layer 8 are preferably set in at least two stages. In the first stage, a film-forming temperature is set to about 1030°C, V/III is set to about 2000, and a growth nucleus (vertical growth layer) of the nitride semiconductor layer 8 is formed on the ridge portion RJ. A thickness (height) of the growth nucleus may be from about 1 µm to about 3 µm, and a width thereof may be about the same as the width of the ridge portion RJ or may have a size slightly protruding in the a-axis direction (<11-20> direction). In the second stage, the film-forming temperature was raised by about 100°C to grow the GaN layer in the lateral direction (a-axis direction) from the growth nucleus, and the growth was stopped when a width of the gap GP between the nitride semiconductor layers 8 (GaN layers) growing in the directions opposite to each other on the void space JS reached a specified value (for example, 10 µm or less). The semiconductor substrate 10 obtained as described above (where the nitride semiconductor layer 8 is exposed) may be taken out from the MOCVD apparatus and stocked, or subsequently, the functional layer 9 including the active layer and the like may be formed in the MOCVD apparatus.

The first wing portion W1 may have a ratio of a width with respect to a thickness of 5.0 or more in the first direction X. The first wing portion W1 may have a width of 7.0 µm or more in the first direction X. A width of the gap GP may be larger than the thickness (height) of the void space JS. A ratio of the width of the first wing portion W1 with respect to the width of the ridge portion RJ may be 3.0 or more. The thickness (height) of the void space JS may be 3.0 µm or less. The thickness of the mask portion 5 may be 50 nm, or less. The seed portion 3 may be made of a nitride semiconductor containing 2 × 10¹⁸/cm³ or more of argon or oxygen.

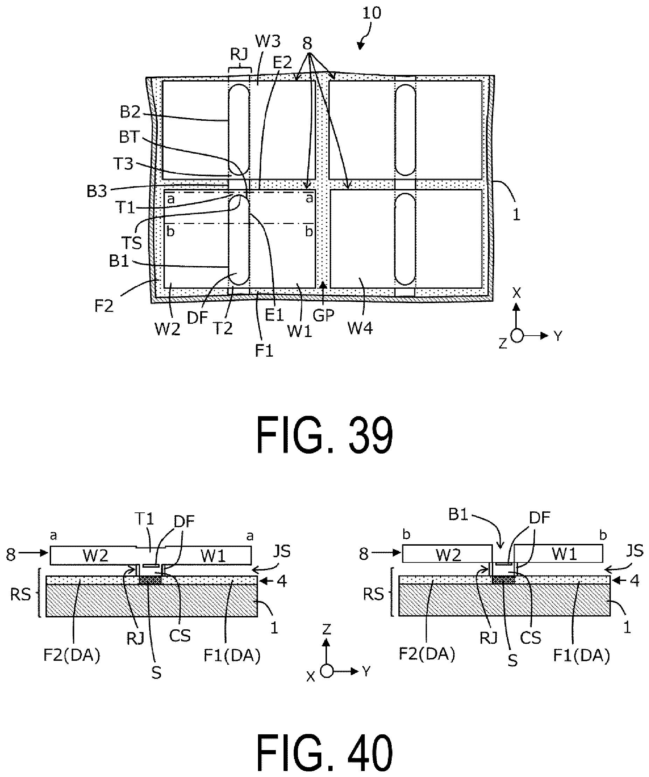

FIG. 39 is a plan view illustrating a configuration example of a semiconductor substrate according to the present embodiment. FIG. 40 is examples of a cross-sectional view taken along a line a-a and a cross-sectional view taken along a line b-b in FIG. 39. As illustrated in FIGs. 39 and 40, the semiconductor substrate 10 includes the ridge substrate RS including the ridge portion RJ extending in the first direction X and the first surface portion F1 and the second surface portion F2, which are located lower than the ridge portion RJ and adjacent to each other via the ridge portion RJ, and the nitride semiconductor layer 8 located on the ridge substrate RS, and the nitride semiconductor layer 8 includes the first tether portion T1 located on the ridge portion RJ, the first wing portion W1 connected to the first tether portion T1 in a state of floating off the first surface portion F1, and the first recessed portion B1 located on the ridge portion RJ and having a shape recessed with respect to the first tether portion T1. The ridge portion RJ includes a crystal portion CS connected to the nitride semiconductor layer 8 and a growth suppression film DF in contact with the crystal portion CS.

The ridge substrate RS may include the main substrate 1 having a lattice constant different from that of the nitride semiconductor layer 8. The nitride semiconductor layer 8 may contain a GaN-based semiconductor, and the main substrate 1 may be a silicon substrate or a silicon carbide substrate. The ridge substrate RS includes an underlying layer 4 located above the main substrate 1, the underlying layer 4 includes the seed region S and the first surface portion F1 (growth suppression region DA), and the crystal portion CS may be located on the seed region S. In the ridge RS substrate, a modified region and an unmodified region are formed in the underlying layer 4, the unmodified region functions as the seed region S, and the modified region functions as the growth suppression region (non-seed region) DA. The modified regions (F1 and F2) can be formed by performing plasma treatment or the like on the underlying layer 4 (for example, an AlN layer).

In the semiconductor substrate 10 of FIGs. 39 and 40, the crystal portion CS (for example, GaN-based semiconductor crystal) on the seed region S (unmodified region) and the growth suppression film DF (for example, a silicon nitride film) in contact with the crystal portion CS are continuously formed, and then the first wing portion W1 can be laterally grown in a state of floating off the first surface portion F1 (growth suppression region DA).

The nitride semiconductor layer 8 may include the second wing portion W2 connected to the first tether portion T1 in a state of floating off the second surface portion F2 (growth suppression region DA). The nitride semiconductor layer 8 may include the second tether portion T2 located on the ridge portion RJ and spaced apart from the first tether portion T1, and the first wing portion W1 may be connected to the second tether portion T2. With this configuration, the first wing portion W1 can be held by the first and second tether portions T1 and T2, so that the first wing portion W1 becomes more stable. Each of the first tether portion T1 and the second tether portion T2 may be connected to a corresponding one of both end portions of the first wing portion W1 facing each other in the first direction X, and the first recessed portion B1 may be located between the first tether portion T1 and the second tether portion T2.

### Supplementary Note

The foregoing disclosure has been presented for purposes of illustration and description, and not limitation. It is noted that many variations will be apparent to those skilled in the art based on these illustrations and descriptions, and these variations are included in the embodiments.

### REFERENCE SIGNS

1 Main substrate
2 Buffer portion
3 Seed portion
5A First mask portion (first surface portion)
5B Second mask portion (second surface portion)
8 Nitride semiconductor layer
9 Functional layer
9A Active layer
10 Semiconductor substrate
15 Laminate body
20 Semiconductor device
31 Manufacturing apparatus for semiconductor substrate
61, 91 Manufacturing apparatus for semiconductor device
D Electrode
S Seed region
B1 First recessed portion
B2 Second recessed portion
T1 First tether portion
T2 Second tether portion
W1 First wing portion
W2 Second wing portion
W3 Third wing portion
F1 First surface portion
F2 Second surface portion
JD Void space
RJ Ridge portion
RS Ridge substrate

## Claims

1. A semiconductor substrate comprising:
a ridge substrate comprising
a ridge portion extending in a first direction and
a first surface portion and a second surface portion being located lower than the ridge portion and adjacent to each other via the ridge portion; and
a nitride semiconductor layer located on the ridge substrate, wherein
the nitride semiconductor layer comprises
a first tether portion located on the ridge portion,
a first wing portion connected to the first tether portion in a state of floating off the first surface portion, and
a first recessed portion located on the ridge portion and having a shape recessed with respect to the first tether portion.

2. The semiconductor substrate according to claim 1, wherein the nitride semiconductor layer comprises a second wing portion connected to the first tether portion in a state of floating off the second surface portion.

3. The semiconductor substrate according to claim 1, wherein
the nitride semiconductor layer comprises a second tether portion located on the ridge portion and spaced apart from the first tether portion, and
the first wing portion is connected to the second tether portion.

4. The semiconductor substrate according to claim 3, wherein each of the first tether portion and the second tether portion is connected to a corresponding one of both end portions of the first wing portion facing each other in the first direction.

5. The semiconductor substrate according to claim 3, wherein the first recessed portion is located between the first tether portion and the second tether portion.

6. The semiconductor substrate according to claim 1, wherein
the nitride semiconductor layer comprises a second recessed portion located on the ridge portion and having a shape recessed with respect to the first tether portion, and
the first tether portion is located between the first recessed portion and the second recessed portion.

7. The semiconductor substrate according to claim 1, wherein a bottom of the first recessed portion reaches the ridge portion.

8. The semiconductor substrate according to claim 1, wherein a bottom of the first recessed portion does not reach the ridge portion.

9. The semiconductor substrate according to claim 1, wherein an upper surface of the ridge portion is a seed region.

10. The semiconductor substrate according to claim 1, wherein the nitride semiconductor layer comprises a third wing portion spaced apart from the first wing portion in the first direction in a state of floating off the first surface portion.

11. The semiconductor substrate according to claim 10, wherein
the nitride semiconductor layer comprises
a third tether portion located on the ridge portion, and
a third recessed portion located on the ridge portion and having a shape recessed with respect to the third tether portion,
the third recessed portion is located between the first tether portion and the third tether portion, and
the third wing portion is connected to the third tether portion.

12. The semiconductor substrate according to claim 10, wherein the third wing portion is connected to the first tether portion.

13. The semiconductor substrate according to claim 1, wherein each of the first surface portion and the second surface portion has a growth suppressing function.

14. The semiconductor substrate according to claim 13, wherein
the first surface portion is a first mask portion,
the second surface portion is a second mask portion, and
the first wing portion is located over the first mask portion via a hollow portion.

15. The semiconductor substrate according to claim 1, wherein the ridge substrate comprises a main substrate having a lattice constant different from a lattice constant of the nitride semiconductor layer.

16. The semiconductor substrate according to claim 15, wherein the ridge portion comprises part of the main substrate.

17. The semiconductor substrate according to claim 1, wherein a thickness of the first tether portion is smaller than a thickness of the first wing portion.

18. The semiconductor substrate according to claim 1, wherein a ratio of a surface area of the first wing portion to a surface area of the first tether portion is 10 or more.

19. The semiconductor substrate according to claim 1, wherein the first wing portion comprises a first notch portion adjacent to the first tether portion.

20. The semiconductor substrate according to claim 19, wherein
the first wing portion comprises a second notch portion adjacent to the first tether portion, and
a straight line connecting a frond end of the first notch portion and a frond end of the second notch portion is oblique to the first direction in plan view.

21. The semiconductor substrate according to claim 20, wherein the straight line is parallel to an m-plane of the nitride semiconductor layer.

22. The semiconductor substrate according to claim 1, wherein a tapered surface of an upwardly narrowing type is comprised in a side surface of the first wing portion.

23. The semiconductor substrate according to claim 1, wherein a size of the first tether portion in the first direction is one fourth or less a size of the first wing portion in the first direction.

24. The semiconductor substrate according to claim 1, wherein
a functional layer comprising an active layer is comprised above the ridge substrate, and
the functional layer is located above the first wing portion.

25. The semiconductor substrate according to claim 24, wherein the functional layer is located above the first tether portion.

26. The semiconductor substrate according to claim 24, wherein the functional layer does not overlap the first recessed portion in plan view.

27. The semiconductor substrate according to claim 24, wherein the functional layer overlaps the first recessed portion in plan view.

28. The semiconductor substrate according to claim 15, wherein
the nitride semiconductor layer contains a GaN-based semiconductor, and
the main substrate is a silicon substrate, a sapphire substrate, or a silicon carbide substrate.

29. The semiconductor substrate according to claim 15, wherein
the ridge portion comprises
a crystal portion connected to the nitride semiconductor layer, and
a growth suppression film in contact with the crystal portion.

30. The semiconductor substrate according to claim 29, wherein
the ridge substrate comprises an underlying layer located above the main substrate,
the underlying layer comprises a seed region and a non-seed region being the first surface portion, and
the crystal portion is located on the seed region.

31. The semiconductor substrate according to claim 30, wherein
the non-seed region is a modified region of the underlying layer, and
the seed region is an unmodified region of the underlying layer.

32. A manufacturing method for a semiconductor substrate, comprising the steps of:
forming a nitride semiconductor layer on a ridge substrate, the ridge substrate comprising
a ridge portion extending in a first direction and a first surface portion and a second surface portion being located lower than the ridge portion and adjacent to each other via the ridge portion; and
patterning the nitride semiconductor layer to form a first tether portion located on the ridge portion, a first wing portion connected to the first tether portion in a state of floating off the first surface portion, and a first recessed portion located on the ridge portion and having a shape recessed with respect to the first tether portion.

33. A manufacturing method for a semiconductor device, comprising the steps of:
preparing a semiconductor substrate comprising a ridge substrate comprising a ridge portion extending in a first direction and a first surface portion and a second surface portion being located lower than the ridge portion and adjacent to each other via the ridge portion, a nitride semiconductor layer located on the ridge substrate, and a functional layer, the nitride semiconductor layer comprising a first tether portion located on the ridge portion, a first wing portion connected to the first tether portion in a state of floating off the first surface portion, and a first recessed portion located on the ridge portion and having a shape recessed with respect to the first tether portion, and the functional layer being located above the first wing portion; and
separating the first wing portion and the first tether portion from each other.

34. A manufacturing method for a semiconductor device, comprising the steps of:
preparing a semiconductor substrate comprising a ridge substrate comprising a ridge portion extending in a first direction and a first surface portion and a second surface portion being located lower than the ridge portion and adjacent to each other via the ridge portion, and a nitride semiconductor layer located on the ridge substrate, the nitride semiconductor layer comprising a first tether portion located on the ridge portion, a first wing portion connected to the first tether portion in a state of floating off the first surface portion, and a first recessed portion located on the ridge portion and having a shape recessed with respect to the first tether portion; and
forming a functional layer on the first wing portion.

35. A manufacturing method for a semiconductor device, comprising the steps of:
preparing a semiconductor substrate comprising a ridge substrate comprising a ridge portion extending in a first direction and a first surface portion and a second surface portion being located lower than the ridge portion and adjacent to each other via the ridge portion, and a nitride semiconductor layer located on the ridge substrate and being not in contact with the first surface portion and the second surface portion;
forming a functional layer on the nitride semiconductor layer; and
after the forming of the functional layer, patterning the nitride semiconductor layer to form, in the nitride semiconductor layer, a first tether portion located on the ridge portion, a first wing portion connected to the first tether portion in a state of floating off the first surface portion, and a first recessed portion located on the ridge portion and having a shape recessed with respect to the first tether portion.

36. The manufacturing method for a semiconductor substrate, according to claim 32, wherein the nitride semiconductor layer is formed by an ELO method.

37. The manufacturing method for a semiconductor device, according to claim 33 or 34, wherein the functional layer comprises an active layer having a quantum-well structure containing a GaN-based semiconductor.

38. The manufacturing method for a semiconductor device, according to claim 34 or 35, further comprising separating the first tether portion and the first wing portion from each other.

39. A manufacturing apparatus for a semiconductor substrate, the apparatus being configured to perform each of the steps described in claim 32.

40. A manufacturing apparatus for a semiconductor device, the apparatus being configured to perform each of the steps described in any one of claims 33 to 35.
